(19) Europäisches Patentamt

European Patent Office

Office européen des brevets

(11) EP 0 911 889 B1

(12) **EUROPÄISCHE PATENTSCHRIFT**

(45) Veröffentlichungstag und Bekanntmachung des Hinweises auf die Patenterteilung:
**04.01.2006  Patentblatt 2006/01**

(51) Int Cl.:
*H01L 39/14* *(2006.01)*     *H02H 9/02* *(2006.01)*

(21) Anmeldenummer: **98810990.6**

(22) Anmeldetag: **01.10.1998**

(54) **Hochtemperatursupraleiter-Anordnung**

High temperature superconducting device

Dispositif supraconducteur à haute température

(84) Benannte Vertragsstaaten:
**CH DE FI FR GB LI**

(30) Priorität: **24.10.1997  DE 19746976**

(43) Veröffentlichungstag der Anmeldung:
**28.04.1999  Patentblatt 1999/17**

(73) Patentinhaber: **ABB RESEARCH LTD.**
**8050 Zürich (CH)**

(72) Erfinder:
• **Chen, Makan, Dr.**
**5405 Baden-Dättwil (CH)**
• **Lakner, Martin, Dr.**
**5413 Birmenstorf (CH)**
• **Paul, Willi, Dr.**
**5430 Wettingen (CH)**

(74) Vertreter: **ABB Patent Attorneys**
**c/o ABB Schweiz AG**
**Brown Boveri Strasse 6**
**5400 Baden (CH)**

(56) Entgegenhaltungen:
**WO-A-96/10269          DE-A- 4 418 050**

• **PATENT ABSTRACTS OF JAPAN vol. 018, no. 008 (E-1486), 7. Januar 1994 & JP 05 251761 A (MITSUBISHI ELECTRIC CORP), 28. September 1993**

**Beschreibung**

TECHNISCHES GEBIET

Bei der Erfindung wird ausgegangen von einer Hochtemperatursupraleiter-Anordnung nach dem Oberbegriff des Patentanspruchs 1.

STAND DER TECHNIK

Mit dem Oberbegriff des Patentanspruchs 1 nimmt die Erfindung auf einen Stand der Technik Bezug, wie er aus der DE 4418050 A1 bekannt ist. Dort ist ein für Strombegrenzeranwendungen geeigneter hohlzylindrischer Hochtemperatursupraleiter mit einer Wandstärke von 3 mm angegeben, der ein- oder beidseitig mit einer 1 $\mu$m dicken Silberschicht überzogen sein kann. Darauf oder direkt auf der Innenfläche des Hochtemperatursupraleiters kann eine 10 $\mu$m dicke 2. Metallschicht oder -folie aus Silber oder Aluminium oder eine 100 $\mu$m dicke Schicht oder Folie aus Blei oder Antimon oder Indium oder Wismut oder Stahl oder Zinn oder Zink oder aus einer Legierung dieser Metalle aufgebracht sein. Diese Schichten sind mit einem elastischen Stahldraht umwickelt und durch ein Lot oder ein kältebeständiges Kunst- oder Epoxidharz fixiert.

Für einen Einsatz eines Hochtemperatursupraleiters als Strombegrenzer in Wechselstromleitungen, insbesondere für elektrische Leistungen von ≥ 1 MW, ist die Verwendung eines elektrischen Bypasses wünschenswert, dessen elektrischer Widerstand kleiner ist als derjenige des Hochtemperatursupraleiters im nicht supraleitenden Zustand, da sonst kritische heiße Stellen auftreten können. Insbesondere sollte der keramische Hochtemperatursupraleiter eine Bypaßschicht aufweisen, deren spezifischer elektrischer Widerstand gegenüber demjenigen einer reinen Edelmetall-Bypaßschicht um mehr als das 10fache erhöht ist, um eine wirtschaftliche Strombegrenzung zu ermöglichen.

Aus dem American Institute of Physics Handbook, herausgegeben von D. E. Gray, McGraw-Hill Book Company, New York 1965, 3. Ausgabe, Seite 9-42, ist es u. a. bekannt, daß der spezifische elektrische Widerstand von Wismut bei 80 K 30 $\mu\Omega \cdot$ cm beträgt.

Aus der DE 4107685 A1 ist ein supraleitender Strombegrenzer bekannt, bei welchem ein 2 mm breiter und 2 mm dicker bifilar gewickelter, keramischer Supraleiter über eine elektrische Isolierschicht aus Zirkoniumdioxid, Strontiumtitanat oder Diamant mit einem Träger aus Keramik, Diamant oder Metall in Verbindung steht.

DARSTELLUNG DER ERFINDUNG

Die Erfindung, wie sie im Patentanspruch 1 definiert ist, löst die Aufgabe, eine Hochtemperatursupraleiter-Anordnung der eingangs genannten Art derart zu verbessern, daß bei einem Einsatz als Strombegrenzer für elektrische Leistungen von ≥ 1 MW keine separate heiße Stellen auftreten.

Vorteilhafte Ausgestaltungen der Erfindung sind in den abhängigen Patentansprüchen definiert.

KURZE BESCHREIBUNG DER ZEICHNUNGEN

Die Erfindung wird nachstehend anhand von Ausführungsbeispielen erläutert. Es zeigen:

Fig. 1    einen Hochtemperatursupraleiter mit 2 direkt angrenzenden Bypaßschichten aus Stahl und

Fig. 2    eine Schichtenfolge eines Hochtemperatursupraleiters mit mehreren Bypaßschichten an einer seiner Hauptflächen und einer Trägerschicht an seiner 2. Hauptfläche.

WEGE ZUR AUSFÜHRUNG DER ERFINDUNG

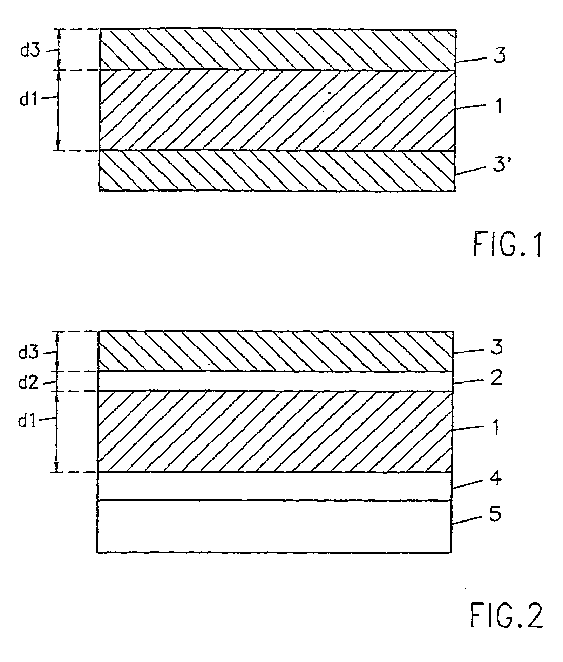

Gemäß Fig. 1 steht eine Schicht aus einem keramischen Hochtemperatursupraleiter (1), der eine gleichmäßige Supraleiter-Schichtdicke (d1) im Bereich von 50 $\mu$m - 2 mm, vorzugsweise im Bereich von 100 $\mu$m - 400 $\mu$m aufweist, über jede seiner beiden Hauptflächen in gutem elektrischem und wärmeleitendem Kontakt mit je einer nichtmagnetischen Nichtedelmetall-Bypaßschicht (3, 3'), vorzugsweise aus Ni-Cr-Stahl mit 18 % Ni und 8 % Cr oder aus einer Nickellegierung mit wechselnden Mengen von Mo, Cr, Mn, Cu, Si, Fe, wie sie unter dem Handelsnamen Hastelloy bekannt ist, oder aus einer Cu-Ni-Legierung. Jede Nichtedelmetall-Bypaßschicht (3, 3') weist eine gleichmäßige Nichtedelmetall-Bypaßschichtdicke (d3) von < 1 mm, vorzugsweise von < 500 $\mu$m auf. Die Nichtedelmetall-Bypaßschichten (3, 3') dienen gleichzeitig als Wärmesenken.

Bei der Ausführung gemäß Fig. 2 ist zwischen dem Hochtemperatursupraleiter (1) und einer nichtmagnetischen, thermisch leitfähigen Nichtedelmetall-Bypaßschicht (3) eine Edelmetall-Bypaßschicht (2), vorzugsweise aus Silber oder aus einer Silberlegierung, vorgesehen, welche eine Bypaßschichtdicke bzw. Edelmetall-Bypaßschichtdicke (d2) im Be-

reich von 10 μm - 300 μm, vorzugsweise im Bereich von 10 μm - 50 μm aufweist. Die Nichtedelmetall-Bypaßschicht (3) wird isostatisch gegen die edelmetallhaltige Bypaßschicht (2) gedrückt; sie könnte auch angeklebt oder angelötet sein. Die Supraleiter-Schichtdicke (d1) liegt im Bereich von 0,5 μm - 5 μm.

Der Hochtemperatursupraleiter (1) ist vorzugsweise yttriumhaltig oder vom Typ: $Bi_{2+x}EA_3Cu_2O_y$ mit -0,15 < x < 0,4, 8 ≤ y ≤ 8,3, EA = ein Erdalkalimetall oder ein Gemisch aus Erdalkalimetallen, insbesondere ein Gemisch aus Sr und Ca im Verhältnis

$$Sr : Ca = (2 + z) : (1 - z) \text{ mit } 0 < z < 0,2.$$

Die Edelmetall-Bypaßschicht (2) besteht vorzugsweise aus Silber (Ag), das mit Blei (Pb) und/oder Wismut (Bi) und/oder Zinn (Sn) und/oder Indium (In) und/oder Gallium (Ga) und/oder Aluminium (A1) und/oder Quecksilber (Hg), vorzugsweise mit Blei oder Wismut oder Gallium legiert ist.

Das Legieren der Edelmetall-Bypaßschicht (2), z. B. mit einer 65Bi30Pb5Ag-Legierung mit einem Schmelzpunkt von 120 °C, erfolgt vorzugsweise durch Diffundieren der Nichtedelmetalle mittels einer thermischen Behandlung.

Ein Verhältnis von einer Bypaß-Schichtdicke (d2) der Edelmetall-Bypaßschicht (2) zur Supraleiter-Schichtdicke (d1) ist auf < 1/5 einzustellen.

Die 2. Hauptfläche des Hochtemperatursupraleiters (1) steht über eine elektrische Isolierschicht (4) mit einer Trägerschicht (5) zur mechanischen Stabilisierung der Hochtemperatursupraleiter-Anordnung in Verbindung. Die Isolierschicht (4) besteht vorzugsweise aus Zirkoniumdioxid $ZrO_2$ oder Zer(III)-oxid $Ce_2O_3$. Die Trägerschicht (5) besteht vorzugsweise aus einem Stahlband oder aus Saphir. Dafür kann auch ein faserverstärkter Kunststoff verwendet werden, wobei die Isolierschicht (4) entfallen kann.

Wichtig ist, daß der spezifische elektrische Widerstand jeder dieser Nichtedelmetall-Bypaßschichten (3, 3') bei 77 K im Bereich zwischen 10 μΩ · cm und 100 μΩ · cm liegt. Wird als Nichtedelmetall-Bypaßschicht (3, 3') eine Stahlschicht verwendet, so sollte eine Stahlschichtdicke (d3) im Bereich von 200 μm - 2 mm, vorzugsweise im Bereich von 200 μm - 500 μm liegen.

Die Edelmetall-Bypaßschichtdicke d2 und die Nichtedelmetall-Bypaßschichtdicke d3 sind so zu wählen, daß ein Verhältnis $\rho2/d2 > 0,5 \cdot \rho3/d3$ ist, wobei $\rho2$ bzw. $\rho3$ den spezifischen elektrischen Widerstand der edelmetallhaltigen Bypaßschicht (2) bzw. der Nichtedelmetall-Bypaßschicht (3, 3') bedeuten.

Gleichzeitig muß $\dfrac{1}{j_c \cdot d1} \cdot \dfrac{1}{50} \dfrac{V}{cm} \leq \dfrac{\rho3}{d3} \leq \dfrac{1}{j_c^2 \cdot d1^2} \cdot 50 \dfrac{W}{cm^2}$ sein, wobei $j_c$ die kritische Stromdichte des Hochtemperatursupraleiters (1) gemessen in $A/cm^2$, d1 dessen Dicke gemessen in cm, d3 die Dicke der Nichtedelmetall-Bypaßschicht (3, 3') gemessen in cm und $\rho3$ deren spezifischer Widerstand gemessen in Ωcm ist.

Ausführungsbeispiel 1:

Zur Herstellung dieser Hochtemperatursupraleiter-Anordnung wird auf eine 0,5 mm dicke, mit Löchern versehene Stahlplatte eine dünne Schicht Lot, das bei 120 °C schmilzt, abgeschieden. Danach wird diese Stahlplatte mit ihrer Lotschicht auf die edelmetallhaltige Bypaßschicht (2) des fertigen Hochtemperatursupraleiters (1) (mit Isolierschicht (4) und Trägerschicht (5)) gelegt und unter Vakuum 10 min lang bei 120 C erhitzt, danach auf Zimmertemperatur abgekühlt. Dadurch wird die Stahlplatte mit der edelmetallhaltigen Bypaßschicht (2) verlötet.

Ausführungsbeispiel 2:

Auf einen Hochtemperatursupraleiter (1) mit einer Silberschicht (2) wird supraleiterseitig mittels eines elektrisch leitfähigen Epoxidharzes eine gelochte Stahlplatte (3) aufgeklebt. Danach wird die Silberschicht mechanisch entfernt und eine weitere Stahlschicht (3') auf die gegenüberliegende Hauptfläche des Hochtemperatursupraleiters (1) aufgebracht.

BEZEICHNUNGSLISTE

1      Hochtemperatursupraleiter
2      Edelmetall-Bypaßschicht, Silberschicht, edelmetallhaltige Bypaßschicht, Silberlegierungsschicht
3, 3'    Nichtedelmetall-Bypaßschicht, Stahlschicht
4      Isolierschicht
5      Trägerschicht
d1     Supraleiter-Schichtdicke
d2     Edelmetall-Bypaßschichtdicke, Bypaßschichtdicke
d3     Nichtedelmetall-Bypaßschichtdicke, Stahlschichtdicke

## Patentansprüche

**1.** Hochtemperatursupraleiter-Anordnung

a) mit einem schichtförmigen, keramischen Hochtemperatursupraleiter (1) mit einer kritischen Stromdichte $j_c$,

b) welcher eine Supraleiter-Schichtdicke d1 im Bereich von 0,5 $\mu$m - 2 mm aufweist, und

c) der über mindestens eine seiner beiden Hauptflächen mit mindestens einer elektrischen Nichtedelmetall-Bypaßschicht (3, 3') mit einer Dicke d3 in gut wärme- und elektrisch leitender Verbindung steht, und zwischen dem Hochtemperatursupraleiter und mindestens einer Nichtedelmetall-Bypaßschicht (3,3') eine edelmetallhaltige Bypaßschicht (2) angeordnet ist sodaß das Verhältnis von Edelmetall-Bypaßschichtdicke (d2) zu einer Supraleiter-Schichtdicke d1 <1/5 ist>

d) wobei der spezifische elektrische Widerstand p3 dieser mindestens einen Nichtedelmetall-Bypaßschicht (3, 3') bei 77 K im Bereich zwischen 10 $\mu\Omega \cdot$ cm und 100 $\mu\Omega \cdot$ cm liegt,

**dadurch gekennzeichnet**,

e) daß für den Flächenwiderstand $\rho3/d3$ der Nichtedelmetall-Bypaßschicht (3, 3') gilt:

$$\frac{1}{j_c \cdot d1} \cdot \frac{1}{50}\frac{V}{cm} \leq \frac{\rho3}{d3} \leq \frac{1}{j_c^2 \cdot d1^2} \cdot 50\frac{W}{cm^2} \;.$$

**2.** Hochtemperatursupraleiter-Anordnung nach Anspruch 1, **dadurch gekennzeichnet, daß** die mindestens eine Nichtedelmetall-Bypaßschicht (3, 3') auf den Hochtemperatursupraleiter (1) geklebt oder gelötet ist.

**3.** Hochtemperatursupraleiter-Anordnung nach Anspruch 2, **dadurch gekennzeichnet, daß** die mindestens eine Nichtedelmetall-Bypaßschicht (3) mittels eines elektrisch leitfähigen Epoxidharzes auf den Supraleiter (1) geklebt ist.

**4.** Hochtemperatursupraleiter-Anordnung nach Anspruch 1, **dadurch gekennzeichnet, daß** die mindestens eine Nicht-edelmetall-Bypaßschicht (3, 3') eine Stahlschicht mit einer Nichtedelmetall-Bypaßschichtdicke (d3) im Bereich von 200 $\mu$m - 2 mm ist.

**5.** Hochtemperatursupraleiter-Anordnung nach Anspruch 1, **dadurch gekennzeichnet, daß** der Supraleiter (1) eine Schichtdicke (d1) im Bereich von 50 $\mu$m - 2 mm aufweist.

**6.** Hochtemperatursupraleiter-Anordnung nach Anspruch 1, **dadurch gekennzeichnet, daß** ein Verhältnis $\rho2/d2 > 0,5 \cdot \rho3/d3$ ist, wobei p2 bzw. p3 den spezifischen elektrischen Widerstand der edelmetallhaltigen Bypaßschicht (2) bzw. der Nichtedelmetall-Bypaßschicht (3, 3') und d2 bzw. d3 deren Schichtdicke bedeuten.

## Claims

**1.** High-temperature superconductor arrangement

a) comprising a layer-type, ceramic high-temperature superconductor (1) with a critical current density $j_c$,

b) which has a superconductor layer thickness d1 in the range from 0.5 $\mu$m - 2 mm, and

c) which is in good thermally and electrically conducting contact via at least one of its two principal surfaces with at least one electrical base-metal bypass layer (3, 3') with a thickness d3, and a noble-metal-containing bypass layer (2) is disposed between the high-temperature superconductor and at least one base-metal bypass layer (3, 3'), so that the ratio of noble-metal bypass layer thickness (d2) to superconductor layer thickness d1 is < 1/5,

d) wherein the electrical resistivity p3 of this at least one base-metal bypass layer (3, 3') is in the range between 10 $\mu\Omega \cdot$ cm and 100 $\mu\Omega \cdot$ cm at 77 K,

**characterized**

e) in that the relationship: $\dfrac{1}{j_c \cdot d1} \cdot \dfrac{1}{50} \dfrac{V}{cm} \leq \dfrac{p3}{d3} \leq \dfrac{1}{j_c^2 \cdot d1^2} \cdot 50 \dfrac{W}{cm^2}$ applies to the sheet resistance p3/d3 of the base-metal bypass layer (3, 3').

2. High-temperature superconductor arrangement according to Claim 1, **characterized in that** the at least one base-metal bypass layer (3, 3') is adhesively bonded or soldered to the high-temperature superconductor (1).

3. High-temperature superconductor arrangement according to Claim 2, **characterized in that** the at least one base-metal bypass layer (3) is adhesively bonded to the superconductor (1) by means of an electrically conductive epoxy resin.

4. High-temperature superconductor arrangement according to Claim 1, **characterized in that** the at least one base-metal bypass layer (3, 3') is a steel layer having a base-metal bypass layer thickness (d3) in the 200 $\mu$m - 2 mm range.

5. High-temperature superconductor arrangement according to Claim 1, **characterized in that** the superconductor (1) has a layer thickness (d1) in the 50 $\mu$m - 2 mm range.

6. High-temperature superconductor arrangement according to Claim 1, **characterized in that** a ratio p2/d2 is > 0.5 p3/d3, where p2 and p3 are the electrical resistivity of the noble-metal-containing bypass layer (2) and of the base-metal bypass layer (3, 3'), respectively, and d2 and d3, respectively, are their layer thickness.

**Revendications**

1. Arrangement supraconducteur à haute température

a) comprenant un supraconducteur à haute température (1) en céramique en forme de couche ayant une densité de courant critique jc,

b) lequel présente une épaisseur de couche de supraconducteur d1 dans une plage comprise entre 0,5 $\mu$m et 2 mm, et

c) lequel se trouve en liaison à bonne conduction thermique et électrique par le biais d'au moins une de ses deux surfaces principales avec au moins une couche de bipasse en métal commun électrique (3, 3') ayant une épaisseur d3 et une couche de bipasse contenant du métal noble (2) est disposée entre le supraconducteur à haute température et au moins une couche de bipasse en métal commun (3, 3') de telle sorte que le rapport entre l'épaisseur de la couche de bipasse en métal noble (d2) et une épaisseur de couche de supraconducteur d1 soit < 1/5,

d) la résistance électrique spécifique p3 de cette au moins une couche de bipasse en métal commun (3, 3') à 77 K étant comprise entre 10 $\mu\Omega$.cm et 100 $\mu\Omega$.cm,

**caractérisé en ce que**

e) l'équation suivante s'applique pour la résistance de surface p3/d3 de la couche de bipasse en métal commun

$$(3, 3') : \quad \frac{1}{j_c.d1} \cdot \frac{1}{50} \frac{V}{cm} \leq \frac{\rho 3}{d3} \leq \frac{1}{j_c^2.d1^2} 50 \frac{W}{cm^2}$$

2. Arrangement supraconducteur à haute température selon la revendication 1, **caractérisé en ce que** l'au moins une couche de bipasse en métal commun (3) est collée ou soudée sur le supraconducteur à haute température (1).

**3.** Arrangement supraconducteur à haute température selon la revendication 2, **caractérisé en ce que** l'au moins une couche de bipasse en métal commun (3) est collée sur le supraconducteur (1) au moyen d'une résine époxy conductrice d'électricité.

**4.** Arrangement supraconducteur à haute température selon la revendication 1, **caractérisé en ce que** l'au moins une couche de bipasse en métal commun (3, 3') est une couche d'acier ayant une épaisseur de couche de bipasse en métal commun (d3) comprise entre 200 $\mu$m et 2 mm.

**5.** Arrangement supraconducteur à haute température selon la revendication 1, **caractérisé en ce que** le supraconducteur (1) présente une épaisseur de couche (d1) comprise entre 50 $\mu$m et 2 mm.

**6.** Arrangement supraconducteur à haute température selon la revendication 1, **caractérisé en ce qu'**un rapport p2/d2 est > à 0,5 . p3/d3, p2, respectivement p3 désignant la résistance électrique spécifique de la couche de bipasse en métal noble (2) respectivement de la couche de bipasse en métal commun (3, 3') et d2 respectivement d3 leur épaisseur de couche.

FIG.1

FIG.2